# EUROPEAN PATENT SPECIFICATION

(11) **EP 2 883 068 B1**
(45) Date of publication and mention of the grant of the patent: **09.03.2016**
(21) Application number: 14709329.8
(22) Date of filing: 12.03.2014
(51) Int. Cl.: G01R 31/327, G01R 31/28

(54) **APPARATUS FOR ONLINE MONITORING OF MEDIUM AND HIGH VOLTAGE CIRCUIT BREAKER**
VORRICHTUNG ZUR ONLINEÜBERWACHUNG VON MEDIUM UND HOCHSPANNUNGSSCHUTZSCHALTER
APPAREIL DE SURVEILLANCE EN LIGNE DE DISJONCTEUR HAUTE ET MOYENNE TENSION

(30) Priority: 12.03.2013 EP 13158700
(43) Date of publication of application: 17.06.2015
(73) Proprietor: ABB Technology AG, 8050 Zürich (CH)
(72) Inventor: MADONNA, Gian-Luigi, CH-8112 Otelfingen (CH); ZLATANSKI, Martin, CH-Küsnacht (CH); HOCHLEHNERT, Moritz, 79771 Klettgau-Griessen (DE); MARET, Yannick, CH-5405 Dättwil (CH); UKIL, Abhisek, Singapore 639798 (SG); Marinkovic, Stevan, CH-5430 Wettingen (CH)
(74) Representative: ABB Patent Attorneys
(86) International application number: PCT/EP2014/054842
(87) International publication number: WO 2014/140104

(56) References cited:
- DE-U1-202007 018 709
- US-A1- 2004 189 307
- US-A1- 2012 081 124
- US-B2- 6 963 203

## Description

### Technical field

The present invention relates to circuit breakers for medium and high voltage applications, in particular to measure, for monitoring purpose, the contact ablation of medium and high voltage circuit breakers.

### Related art

Circuit breakers are used for switching electrical connections employed for the supply, generation, distribution and transmission of electrical energy.

When operating circuit breakers for interrupting high currents, an electrical arc is formed that tends to ablate the contact regions of the circuit breaker. Hence, common high-voltage circuit breakers have a pair of arcing contacts and a pair of main contacts which are closed or opened with a time delay when the circuit breaker is operated. In a fully closed condition, arcing and main contact are electrically connected in parallel. While the main contact pair provides very low impedance in closed condition, the arcing contact pair exhibits a higher impedance in closed condition but is designed to withstand arcs. In an open condition, the arcing contact regions of the arcing contact pair are usually situated to each other at a distance closer than that of the main contact regions of the main contact pair. Hence, when the circuit breaker is being closed, the arcing contact regions contact each other first so as to firstly feed the current during closing of the circuit breaker and accept the arc while the main contact regions contact each other after the time delay. Conversely, when the circuit breaker is being opened the main contact regions separate before the arcing contact regions so as to restrict any arcs to the arcing contact.

Due to electrical arc generation in high-voltage/high-current switching operations - opening (and possibly closing) the circuit breaker -the arcing contact regions ablate, which physically reduces their length or hollows out the ablation contact system. This reduced length leads to a decreasing difference between the distances of the arcing contact regions and the main contact regions.

An opening overlapping - defined as the time between opening the main contact and opening the arcing contact - will thus decrease with the lengths of the arcing contact regions. This increases the risk of the formation of an electrical arc between the main contact regions, which would result in damage or destruction of the circuit breaker.

In order to ensure permanent reliable operation of the circuit breaker, the ablation level of the arcing contacts is usually tracked by measuring as overlapping time the time interval between the connection or disconnection timings of the arcing contact pair and main contact pair, respectively. Since a constant displacement velocity is applied for opening and closing the circuit breaker contact pairs, the contact pair contacting timings difference is directly related to the ablation contact length. Monitoring the overlapping time as a critical parameter provides information on the ablation level of the arcing contact pair.

Document US 6,850,072 B1 discloses an apparatus for analyzing the condition of high-voltage circuit breakers. For analyzing the ablation level of the circuit breaker, each of the circuit breaker contacts is electrically coupled to ground, a test voltage is supplied across the circuit breaker contact, an output voltage signal is measured, a state of the circuit breaker contact pair is changed and a step-change of the output voltage is detected that corresponds to the change of the state of the circuit breaker.

Document US 6,963,203 B2 discloses a method for analyzing an electrical contact pair in a circuit breaker. The method includes the steps of electrically coupling the contact to electrical ground, applying a test voltage across the contact pair and measuring the time between a first closure of the contact pair and a first opening of the contact pair using a test voltage as well as determining the timing of the contact pair based on the operation of the contact pair operation timing.
The above documents propose a method and an apparatus for detecting an ablation level of a high-voltage circuit breaker. However, the analysis of the circuit breaker cannot be performed online as both contacts of the circuit breaker have to be grounded to carry out the measurement.

US 2012081124 A1 discloses a system for monitoring the physical state of a DC switch by injection of a transient signal through coupling elements which provide a galvanic insulation. The coupling elements are floating on the potential of the switch.

DE 20 2007 018709 U1 describes a monitoring system for monitoring the contact wear of a circuit breaker with two contact systems. From the time interval between closing or opening of these two contact systems the condition of the circuit breaker is estimated. Current or voltage sensors are used to measure voltage or current signal when switching on or off.

It is an object of the present invention to provide an apparatus for online monitoring the ablation level of contact regions of an arcing contact pair of a circuit breaker which allows for analyzing the condition of the circuit breaker during normal operation of the circuit breaker.

### Summary of the invention

This object has been achieved by the apparatus for monitoring a condition of a circuit breaker according to claim 1 and by the system according to the further independent claims.
Further embodiments of the present invention are indicated in the dependent subclaims.

According to a first aspect, an apparatus for monitoring a condition of a circuit breaker is provided, comprising:
- an injection unit for injecting a test signal into a first contact of the circuit breaker;
- a detection unit for detecting a resulting test signal at a second contact of the circuit breaker;
- a first coupling means for coupling the test signal provided by the injection unit into the first contact; and
- a second coupling means for coupling the detection unit with the second contact to receive the resulting test signal,
wherein at least one of the first and second coupling means provide a galvanic separation to the first and second contacts. The apparatus is characterized in that the first coupling means is connected between the first contact and ground and wherein the second coupling means may be connected between the second contact and ground.

The main contact regions are configured to provide very low impedance in a closed condition. For a normal opening operation of a circuit breaker, the arcing contact regions of the arcing contact pair and the main contact regions of the main contact pair are separated from each other at a different time instant or timing. The main contact regions separate from each other first, so that only the arcing contact pair remains connected. After a further delay and due to the separation movement of the arcing contact regions from each other, the arcing contact pair is disconnected from each other. At that instant, an electric arc may ignite allowing for current flow continuity; when the current reaches zero values (every 10ms at 50Hz), the arc may extinguish itself or be forcefully extinguished. The larger the interrupted current, the more energy is contained in the arc. However, the arcing contact pair is designed/configured to withstand arcs and thus exhibit a relatively higher impedance (substantially higher than the impedance of the main contact regions in closed condition).

For a normal closing operation, the timings are the converse order of those reported for opening. Furthermore, arc creation is then due to the voltage breakdown of the insulation medium within the interruption chamber as the arcing contact regions, with different voltage potentials, move toward each other. Arcs created during closing operations contain much less energy than those created during opening operations and thus only slightly ablate the arcing contact.

The purpose of such a double-switch configuration is to protect the low-impedance main contact pair from the impact of an electric arc which may be caused by the interruption of a large current. Opening (respectively closing) the arcing contact pair after (respectively before) the main contact pair will draw the electrical arc between the arcing contact regions. If they are too degraded the arc may affect the main contact.

In contrast to the main contact regions, the arcing contact regions are designed to better sustain the impact of the electrical arc and are further allowed to be ablated in a controlled manner. Moreover, the arcing contact regions can be replaced once they are degraded up to a specific level.

To detect the ablation level of such a circuit breaker, the circuit breaker condition has to be monitored. The main criterion is that in an opening operation the overlapping time should be sufficiently high. The minimum overlapping time is preset, so that no electrical arc can occur between the main contact regions. If the arcing contact regions are too degraded because too much contact material has been ablated, the distance between the main contact regions is too short at the time instant when the arcing contacts separate. If this is the case, the electric arc may touch the main contact regions. Such a situation may damage the breaker, thus the arcing contact regions should be replaced beforehand.

Because opening operations generate very strong electrical perturbations due to the energy of the arc, it is preferred to measure the timings under closing operations. Closing operation timings indeed relate to those of the opening operations. Measurements techniques are however similar for both types of operations, therefore the description will be often limited to closing in the further text.

One reliable method for monitoring such a circuit breaker is to measure the time delay between the closing of the arcing contact pair and the closing of the main contact pair or, respectively, between the opening of the main contacts and the opening of the arcing contacts. Since the switching velocity, i.e. the velocity at which the contact regions are either moved toward or separated from each other, is assumed to be mostly constant, the time between a condition change, i.e. a closing or opening, of the arcing contact pair and a condition change, i.e. a closing or opening, of the main contact pair provides a good indication about the degradation/shortening/erosion of the arcing contact regions.

In order to detect the closing/opening of the arcing contact pair and the closing/opening of the main contact pair, a transient test signal is used which is injected at a first contact of the circuit breaker and detected at a second contact of the circuit breaker. The transient test signal may preferably correspond to a periodic signal, e.g. a sinusoidal signal at a given frequency. The frequency can vary over time and the waveform can be a more complex AC signal (e.g. square, triangular waves, noise, modulation etc.) and can as well vary over time. Due to the stepped impedance characteristic of the circuit breaker switching process, the injected transient test signal may be detected with different amplitudes after propagating through the circuit breaker, wherein the amplitude and amplitude changes depend on the conditions of the arcing contact and the main contact pairs. In order words, the detected signal is amplitude-modulated according to the dynamic impedance of the circuit breaker, which changes according to the switching condition of the circuit breaker.

To allow injection and detection of the transient test signal while the circuit breaker is in normal operation, galvanic-insulated couplings between a test signal injection unit and a first contact of the circuit breaker and between a test signal detection unit and a second contact of the circuit breaker are provided. This has the advantage that online monitoring of the circuit breaker can be carried out, thereby avoiding downtimes of the high-voltage system.

Furthermore, the first coupling means may comprise a capacitive coupler including a capacitance connecting the injection unit with the first contact to couple the transient test signal into the first contact.

Alternatively, it may be provided that the first coupling means comprises a first transformer in line with a first surge capacitor, i.e. a capacitor connected between a supply line and ground, wherein the injection unit is connected to the first transformer to couple the transient test signal into the first contact.

Moreover, the second coupling means may comprise a capacitive coupler including a capacitor connecting the detection unit with the second contact to receive the resulting test signal from the second contact.

Alternatively, the second coupling means may comprise a second transformer in line with a second surge capacitor, wherein the detection unit is connected to the second transformer to receive the test signal from the second contact.

According to an embodiment, the injection unit may further comprise a first peaking inductor, wherein the frequency of the test signal injected corresponds to a frequency which differs not more than 10% from the resonance frequency determined by the inductance of the first peaking inductor and the inductance and capacitance of the first coupling means.

Particularly, the detection unit may further comprise a second peaking inductor, wherein the resonance frequency that is determined by the inductance of the second peaking inductor and the inductance and capacitance of the second coupling means corresponds to a frequency which differs not more than 10% from the resonant frequency determined by the inductance of the first peaking inductor and the inductance and capacitance of the first coupling means.

It may be provided that a control unit is configured to receive indications about a first time of closing or opening a main (first) contact pair and a second time of closing or opening an arcing (second) contact pair, to determine a time delay between the first and the second time of closing or between the first and the second time of opening and to signal a poor or unsafe condition of the circuit breaker depending on the determined time delay. The indication about the first time of closing or opening a main (first) contact pair can be a reference time depending on a timing of a trigger signal commanding the switching of the circuit breaker. In other words, the reference time is with respect to the contact, which opens first or closes last after commanding the switching.

According to a further aspect, a system comprises a circuit breaker having a first contact and a second contact and the above apparatus.

Moreover, the first contact may have a first main contact region and a first arcing contact region and the second contact may have a second main contact region and a second arcing contact region, wherein the first and second main contact regions form a main contact pair having a lower first impedance in closed condition and wherein the first and second arcing contact regions form an arcing contact pair having a higher second impedance in closed condition, wherein upon closing the circuit breaker the arcing contact pair is closed first and upon opening the circuit breaker the main contact pair is opened first.

According to another aspect a method for measuring a condition of a circuit breaker using the above apparatus is provided, where indications about a first time of closing or opening a main (first) contact pair of a circuit breaker is obtained and a second time of closing or respectively opening an arcing (second) contact pair of a circuit breaker is obtained. A time delay between the first time and second time is determined and a poor condition of the circuit breaker is signalled depending on the determined time delay. The transient test signal is coupled into the first contact and the test signal is detected on the second contact while at least one of the first and second contacts being energized.

### Brief description of the drawings

Preferred embodiments of the present invention are described in more detail in the following description in conjunction with the accompanying drawings, in which:
- Figure 1: schematically shows a system for monitoring the ablation level of a circuit breaker;
- Figure 2: schematically shows a circuit breaker;
- Figure 3: shows a signal-time diagram for the test signal detected at the second contact;
- Figure 4: shows a more detailed diagram of the system according to Figure 1; and
- Figure 5: shows a more detailed diagram of another embodiment of the system according to Figure 1.

### Description of embodiments

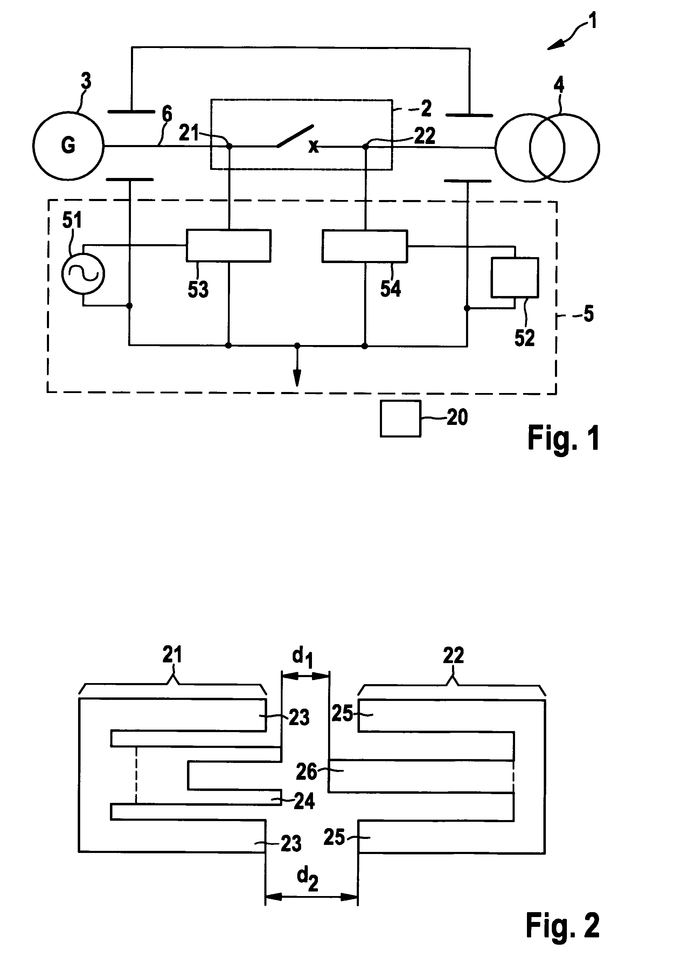

Figure 1 schematically shows a medium-voltage system 1 having a generator circuit breaker 2 which couples a medium-voltage supply 3, provided by e. g. a generator of a power plant or a similar source, to an electrical energy sink 4 such as a transformer, load, an energy supply grid or the like. The circuit breaker 2 is represented here with an optional surrounding metallic enclosure connected to ground. Furthermore, an apparatus 5 for monitoring an ablation level of the circuit breaker 2 is provided.

A cross-section of a circuit breaker 2 interrupting chamber is schematically illustrated in Figure 2. A first contact 21 of the circuit breaker 2 is provided with a first main contact region 23 and a first arcing contact region 24. A second contact 22 of the circuit breaker 2 is provided with a second main contact region 25 and a second arcing contact region 26. The circuit breaker 2 of Figure 2 is depicted in an open condition. In the open condition, the first and second arcing contact regions 24, 26 are distanced from each other by a first distance d₁ and the first and second main contact regions 23, 25 are distanced from each other by a second distance d₂.

The first and second arcing contact regions 24, 26 are formed as mating parts, e. g. the first arcing contact region 24 as a U-shaped contact structure, often called tulip, and the second arcing contact region 26 has a contact structure, often called pin, that can be moved between the legs of the U-shaped contact structure of the first arcing contact region 24. Different mating structures of the contacts can be provided as well.

During a closing operation of the circuit breaker 2, the contact regions of the first and second contacts 21, 22 are moved toward each other. Consequently, the first and second arcing contact regions 24, 26 and the first and second main contact regions 23, 25 are moved toward each other. Due to the shorter first distance d₁, the first and second arcing contact regions 24, 26 contact each other before the first and second main contact regions 23, 25 in a closing operation of the circuit breaker 2.

In a contacting (closed) condition, the first and second arcing contact regions 24, 26 are exhibiting a higher impedance than that of the first and second main contact regions 23, 25 in a contacting condition. The first and second arcing contact regions 24, 26 are configured to allow controlled ablation of the arcing contact regions 24, 26 in case of an interruption of high-current (and feeding of medium-voltage difference). The main task of the arcing contact regions 24, 26 is to support electric arcs and thus to protect the main contact regions 23, 25 to suffer from arcs.

The ablation of the arcing contact regions 24, 26 leads to a reduction of their length or a hollowing out of the ablation contact system. In other words, the distance between the ablation the arcing contact regions 24, 26 is increased. Furthermore, the shorter the length of the first and second arcing contact regions 24, 26 is, the higher is the risk of creating an arc between the first and second main contact regions 23, 25 during an opening operation, which may lead to the destruction of the circuit breaker 2.

The monitoring apparatus 5 comprises an injection unit 51 for injecting a transient, e.g. a periodic test signal into a first contact 21 of the circuit breaker 2 and a detection unit 52 coupled to a second contact 22 of the circuit breaker 2 for detecting the test signal after propagation through the circuit breaker 2.

The monitoring apparatus 5 is provided to monitor the condition of the first and second arcing contact regions 24, 26, so that a state can be signalled to indicate if replacement of the first and second arcing contact regions 24, 26 is required in order to avoid permanent damage.

To inject the periodic test signal into the supply line 6 at the first contact 21 of the circuit breaker 2, a first coupling means 53 is provided. The first coupling means 53 may be connected directly to the first contact 21. To receive the test signal at the second contact 22 of the circuit breaker 2, a second coupling means 54 is provided. The second coupling means 54 may be connected directly to the second contact 22. The first and second coupling means 53, 54 decouple/protect the injection unit 51 and the detection unit 52 from the medium-voltage regime of the supply line 6 by providing galvanic insulation 60 while allowing the test signal to propagate. Thus, the normal operation of the circuit breaker 2 does not need to be interrupted to perform a contact ablation measurement/monitoring. Therefore, the overlapping time measurement can be carried out during normal operation of the circuit breaker 2.

To mask the effect for the periodic test signal the first coupling means 53 may beconnected between the first contact 21 and ground and the second coupling means 54 may be connected between the second contact 22 and the same ground.

Thus, the connection to ground delivers a well defined signal reference and prevents any shift of the test signal.

The test signal return path may be through the breaker enclosure. It may also be provided that the test signal return path does not include the breaker enclosure.

The test signal return path of the first coupling means 53 and of the second coupling means 54 may be also go through the breaker enclosure to ground via a common return path of an interposed electronics.

A control unit 20 is provided which is configured to monitor the condition of the circuit breaker 2. Furthermore, the control unit may be configured to switch the generation of the test signal in the injection unit 51 off when the circuit breaker 2 is not operated.

One way of monitoring the ablation level of the first and second arcing contact regions 24, 26 is to measure the time interval between the connection or disconnection of the first and second arcing contact regions 24, 26 and of the first and second main contact regions 23, 25 during a switching operation. Assuming constant displacement velocities of the contact regions of the circuit breaker 2, the contacting timings are directly linked to the first and second distances d₁, d₂. The critical parameter to be monitored is the change over time of the time interval between the closure of the arcing contact pair and the closure of the main contact pair.

Therefore, the injecting unit 51 is configured to inject a periodic test signal at a frequency much higher than the frequency of the medium voltage on the supply line 6. Frequencies may be between 10 kHz and 100 MHz. The periodic test signal is injected into the first contact 21 of the circuit breaker 2. At the second contact 22 a time interval is measured between the timing of the test signal appearance at the second contact 22, which corresponds to the time of closing the arcing contact pair, and the timing of the change in the received test, which corresponds to the time of closing the main contact pair.

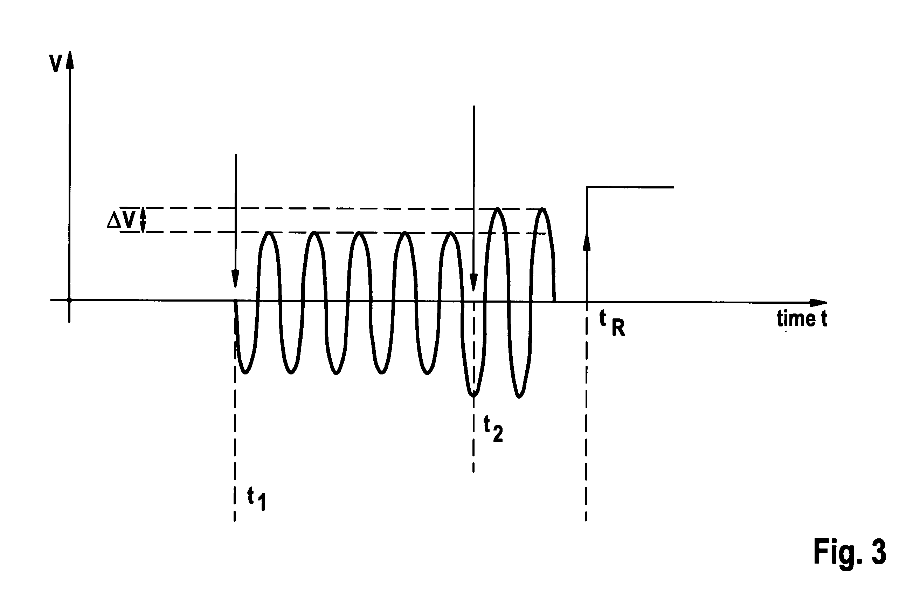

In Figure 3, the signal-time diagram of the test signal tapped at the second contact 22 of the circuit breaker 2 is depicted. It can be seen that at the timing t₁ the test signal is firstly received, thereby indicating the closing of the arcing contact pair. At the timing t₂, the amplitude of the test signal received has changed by a voltage level of ΔV due to the lower impedance of the closed main contact pair, so that the timing t₂ indicates the closing of the main contact pair.

According to a different monitoring scheme and in case the difference in the characteristic of the voltage amplitudes during closing or opening of the main contact pair cannot be detected due to the presence of high levels of noise and interferences, a reference signal at a reference timing t_{R} triggered by the switching of the circuit breaker 2 may be used. The reference timing t_{R} can be provided by a switching control system, wherein the reference timing t_{R} may depend on a timing when the closing of the circuit breaker is started. The reference timing t_{R} may indicate, for example, a timing when the closing operation has securely been finished. In general, the reference timing t_{R} is derived from a system that is mechanically coupled to the moving main contact.

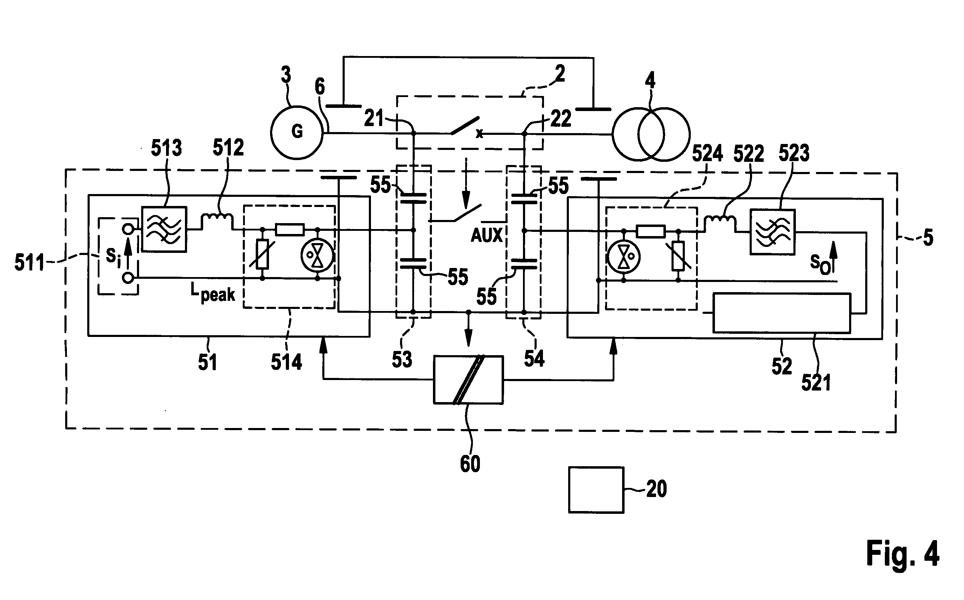

In Figure 4, a more detailed diagram of the system 1 is shown. In particular, in the illustrated embodiment the first and second coupling means 53, 54 are provided as capacitive couplers, each comprising two serially connected capacitors 55. The series connection of the capacitors 55 is coupled between the first contact 21 of the circuit breaker 2 and a ground potential and the series connection of the capacitors 55 of the second coupling means is coupled between the second contact 22 of the circuit breaker 2 and the ground potential. An intermediate node between the capacitors 55 of the series connection of the first coupling means 53 is coupled to the injection unit 51. An intermediate node between the capacitors 55 of the series connection of the second coupling means 54 is connected to the detection unit 52. The bottom capacitors of the capacitive couplers 53, 54, i.e. the capacitor between the intermediate node and the ground potential is not needed for the monitoring system but is often present as a by-product of the capacitive coupler construction or for safety reasons.

The injection unit 51 has a test signal source 511 providing a periodic test signal with a frequency that may correspond to a resonance frequency resulting from the series association of a first peaking inductor 512 and the equivalent capacitance of the capacitors 55 of the first coupling means 53 as well as stray capacitances and inductances of the system. The first peaking inductor 512 is connected in series to a first protection circuit 514, which is located between the intermediate node of the first coupling means 53 and the first peaking inductor 512. The first protection circuit 514 is configured to absorb any high energy transient. Between the first peaking inductor 512 and the test signal source 511 a first band pass filter 513 is provided which further protects any active circuit limiting the energy of an eventual broadband perturbation coming from the circuit breaker 2.

The detection unit 52 provides a second protection stage 524, a second peaking inductor 522, a second bandpass filter 523 and a signal processing unit 521 which is able to receive and process the periodic test signal and to determine and monitor the condition of the circuit breaker 2, i. e. opened, closed or moving. The operation of the second protection stage 524, the second peaking inductor 522 and the second bandpass filter 523 substantially corresponds to the operation of the first protection stage 514, the first peaking inductor 512 and the first bandpass filter 513.

In a switching operation in which the circuit breaker 2 is being closed or being opened, the time interval between the time of closing of the arcing contact pair and the time of closing of the main contact pair or the time interval between the time of opening of the main contact pair and the time of opening of the arcing contact pair, respectively, can be measured by monitoring the voltage amplitude variations of the received test signal.

The signal processing unit 521 is connected to the control unit 20 to receive indications about the timing t₁ and the timing t₂ (and the reference timing t_{R}, respectively) to determine the accurate time delay as a difference. The time delays at each switching operation are compared to a predetermined threshold delay and a degradation of the circuit breaker 2 is signalled if the determined time delay approaches the predetermined threshold delay.

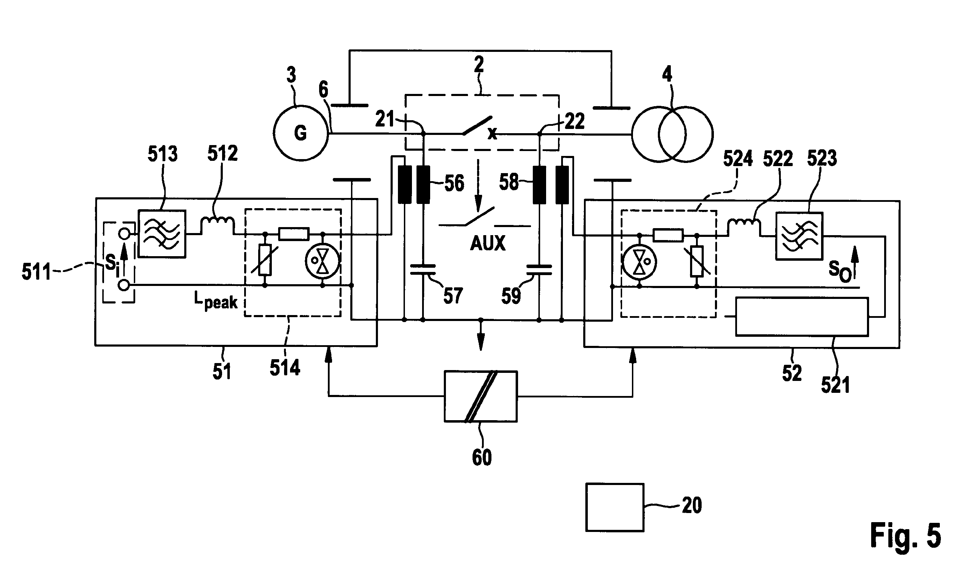

Instead of a capacitive coupling of the test signal into or from the supply line 6, an inductive coupling is also possible, as is shown in the circuit diagram of Figure 5. The inductive coupling can be applied by introducing a first transformer 56 in line with a first surge capacitor 57 between the first contact 21 of the circuit breaker 2 and the ground potential and introducing a second transformer 58 in series with a second surge capacitor 59 between the second contact 22 of the circuit breaker 2 and the ground potential, as shown in Figure 5. According to a further embodiment, a first terminal of the first surge capacitor 57 is directly connected with the first contact 21 and the first transformer 56 is connected between a second terminal of the first surge capacitor 57 and a ground potential. Similarly, a first terminal of the second surge capacitor 59 is directly connected with the second contact 22 and the second transformer 58 is connected between a second terminal of the second surge capacitor 59 and the ground potential.

The periodic test signal is injected by means of the first transformer 56 at a resonant frequency mostly determined by the capacitance of the first surge capacitor 57 and its stray inductance. As for the capacitive coupling case, the inductance of the peaking inductor 512 may be adapted in order to calibrate the resonance frequency. The test signal is detected by means of a secondary side of the second transformer 58. The injection unit 51 and the detection unit 52 substantially correspond to the ones of the embodiment of Figure 4.

### Reference list

- 1: system
- 2: circuit breaker
- 3: medium or high-voltage supply
- 4: electrical energy sink
- 5: monitoring apparatus
- 6: supply line
- 20: control unit
- 21: first contact of the circuit breaker
- 22: second contact of the circuit breaker
- 23: first main contact region
- 24: first arcing contact region
- 25: second main contact region
- 26: second arcing contact region
- 51: injection unit
- 52: detection unit
- 53: first coupling means
- 54: second coupling means
- 55: capacitors
- 56: first transformer
- 57: first surge capacitor
- 58: second transformer
- 59: second surge capacitor
- 60: galvanic insulation
- 511: test signal source
- 512: first peaking inductor
- 513: first bandpass filter
- 514: first protection unit
- 521: signal processing unit
- 522: second peaking inductor
- 523: second bandpass filter
- 524: second protection unit

## Claims

1. Apparatus for monitoring a condition of a circuit breaker (2), comprising:
- an injection unit (51) for injecting a transient test signal into a first contact of the circuit breaker;
- a detection unit (52) for detecting a resulting transient signal at a second contact of the circuit breaker;
- a first coupling means (53) for coupling the transient test signal provided by the injection unit into the first contact (21); and
- a second coupling means (54) for coupling the detection unit to the second contact (22) to receive the resulting test signal,
wherein at least one of the first and second coupling means provide a galvanic separation to the first and second contacts (21, 22),
wherein the first coupling means (53) is connected between the first contact (21) and ground and wherein the second coupling means (54) is connected between the second contact (22) and ground,
**characterized in that**, the first coupling means (53) comprises a capacitive coupler including a capacitance (55) connecting the injection unit (51) with the first contact (21) to couple the transient test signal into the first contact (21) and wherein the injection unit (51) further comprises a first peaking inductor (512), and wherein one frequency of the test signal injected corresponds to a frequency which differs not more than 10% from to the resonance frequency determined by the inductance of the first peaking inductor (512) and the inductance and capacitance of the first coupling means (53).

2. Apparatus for monitoring a condition of a circuit breaker (2), comprising:
- an injection unit (51) for injecting a transient test signal into a first contact of the circuit breaker (2);
- a detection unit (52) for detecting a resulting transient signal at a second contact of the circuit breaker;
- a first coupling means (53) for coupling the transient test signal provided by the injection unit into the first contact (21); and
- a second coupling means (54) for coupling the detection unit to the second contact (22) to receive the resulting test signal,
wherein at least one of the first and second coupling means provide a galvanic separation to the first and second contacts (21, 22),
- wherein the first coupling means (53) is connected between the first contact (21) and ground and wherein the second coupling means (54) is connected between the second contact (22) and ground, **characterized in that** the first coupling means (53) comprises a first transformer (56) in line with a first surge capacitor (57) on a secondary side of the first transformer (56), wherein the injection unit (51) is connected to the first transformer (56) to couple the transient test signal into the first contact (21), wherein a periodic test signal is injected by means of the first transformer (56) at a resonant frequency mostly determined by the capacitance of the first surge capacitor (57) and its stray inductance.

3. Apparatus according to claim 1 or 2, wherein the second coupling means (52) comprises a capacitive coupler including a capacitance (55) connecting the detection unit (54) with the second contact (22) to receive the resulting test signal from the second contact (22).

4. Apparatus according to any one of claims 1 to 3, wherein the second coupling means (54) comprises a second transformer (58) in line with a second surge capacitor (59), wherein the detection unit (52) is connected to the second transformer (58) to receive the transient test signal from the second contact (22).

5. Apparatus according to the claims 1 to 4, wherein the detection unit further comprises a second peaking inductor (522), wherein the resonance frequency that is determined by the inductance of the second peaking inductor (522) and the inductance and capacitance of the second coupling means (54) corresponds to a frequency which differs not more than 10% from the resonant frequency determined by the inductance of the first peaking inductor (512) and the inductance and capacitance of the first coupling means (53).

6. Apparatus according to any one of claims 1 to 5, wherein a control unit (20) is configured to receive indications about a first point in time of closing or opening a main contacts pair (23, 25) and a second point in time of closing or respectively opening an arcing contact pair (24, 26) to determine a time delay between the first and the second point in time of closing or between the first and the second point in time of opening and to signal a poor condition of the circuit breaker (2) depending on the determined time delay.

7. Apparatus according to one of claims 1 or 3, wherein the capacitive couplers of the first and second coupling means (53, 54) are each comprising two serially connected capacitors (55), and wherein the first series connection of the capacitors (55) is coupled between the first contact (21) of the circuit breaker (2) and a ground potential, and the second series connection of the capacitors (55) is coupled between the second contact (22) of the circuit breaker (2) and the ground potential, and wherein an intermediate node between the capacitors (55) of the series connection of the first coupling means (53) is coupled to the peaking inductor (512) of the injection unit (51), and wherein an intermediate node between the capacitors (55) of the series connection of the second coupling means (54) is connected to the peaking inductor (522) of the detection unit (52)

8. Apparatus according to claim 7, wherein the first peaking inductor (512) is connected in series to a first protection circuit (514), which is located between the intermediate node of the first coupling means (53) and the first peaking inductor (512).

9. Control unit (20) for use with an apparatus according to claim 1 to 8, where the control unit (20) is configured to receive indications about a first point in time of closing or opening a main contact pair (23, 25) of a circuit breaker (2) and a second point in time of closing or respectively opening an arcing contact pair (24, 26) of a circuit breaker (2) to determine a time delay and to signal a poor condition of the circuit breaker (2) depending on the determined time delay.

10. System comprising:
- a circuit breaker (2) having a first contact (21) and a second contact (22); and
- an apparatus according to any one of claims 1 to 7.

11. System according to claim 10 and comprising a control unit (20) according to claim 10.

12. System according to claim 10 or 11, wherein the first contact (21) has a first main contact region (23) and a first arcing contact region (24) and the second contact (22) has a second main contact region (25) and a second arcing contact region (26), wherein the first and second main contact regions (23, 25) form a main contact pair (23, 25) having a lower first impedance in closed condition and wherein the first and second arcing contact regions (24, 26) form an arcing contact pair (24, 26) having a higher second impedance in closed condition, wherein when closing the circuit breaker (2) the arcing contact pair (24, 26) is closed first and when opening the circuit breaker (2) the main contact pair (23, 25) is opened first.

13. System according to any one of the claims 10 to 12, wherein the circuit breaker (2) is a generator circuit breaker.

14. Method for measuring a condition of a circuit breaker (2) using an apparatus according to any of the claims 1 to 8, where indications about a first point in time of closing or opening a main contact pair (23, 25) of a circuit breaker (2) is obtained and a second point in time of closing or respectively opening an arcing contact pair (24, 26) of the circuit breaker (2) is obtained, wherein a time delay between the first point in time and second point in time is determined and a poor condition of the circuit breaker (2) is signalled depending on the determined time delay, wherein the transient test signal is coupled into the first contact (21) and the test signal is detected on the second contact (22) while at least one of the first and second contacts being energized.

15. Method according to claim 14, wherein the measurement of the condition of the circuit breaker (2) is performed online during normal operation of the circuit breaker (2).

## Patentansprüche

1. Vorrichtung zur Überwachung eines Zustandes eines Leistungsschalters (2), aufweisend:
- eine Einspeisungseinheit (51) zum Einspeisen eines transienten Prüfsignals in einen ersten Kontakt des Leistungsschalters;
- eine Detektionseinheit (52) zum Detektieren eines resultierenden transienten Signals an einem zweiten Kontakt des Leistungsschalters;
- ein erstes Kopplungsmittel (53) zum Koppeln des transienten Prüfsignals, das von der Einspeisungseinheit in den ersten Kontakt (21) bereitgestellt wird; und
- ein zweites Kopplungsmittel (54) zum Koppeln der Detektionseinheit mit dem zweiten Kontakt (22), um das resultierende Prüfsignal zu empfangen,
wobei mindestens eines vom dem ersten und zweiten Kopplungsmittel eine galvanische Trennung zu den ersten und zweiten Kontakten (21, 22) bereitstellt,
wobei das erste Kopplungsmittel (53) zwischen dem ersten Kontakt (21) und Erde verbunden ist, und wobei das zweite Kopplungsmittel (54) zwischen dem zweiten Kontakt (22) und Erde verbunden ist,
**dadurch gekennzeichnet, dass** das erste Kopplungsmittel (53) einen kapazitiven Koppler umfasst, der eine Kapazität (55) aufweist, welche die Einspeisungseinheit (51) mit dem ersten Kontakt (21) verbindet, um das transiente Prüfsignal in den ersten Kontakt (21) zu koppeln, und wobei die Einspeisungseinheit (51) ferner einen ersten Resonanzinduktor (512)umfasst, und wobei eine Frequenz des eingespeisten Prüfsignals einer Frequenz entspricht, die sich nicht mehr als 10% von der Resonanzfrequenz unterscheidet, die durch die Induktivität des ersten Resonanzinduktors (512) und die Induktivität und Kapazität des ersten Kopplungsmittels (53) bestimmt wird.

2. Vorrichtung zur Überwachung eines Zustandes eines Leistungsschalters (2), aufweisend:
- eine Einspeisungseinheit (51) zum Einspeisen eines transienten Prüfsignals in einen ersten Kontakt des Leistungsschalters (2);
- eine Detektionseinheit (52) zum Detektieren eines resultierenden transienten Signals an einem zweiten Kontakt des Leistungsschalters;
- ein erstes Kopplungsmittel (53) zum Koppeln des transienten Prüfsignals, das von der Einspeisungseinheit in den ersten Kontakt (21) bereitgestellt wird; und
- ein zweites Kopplungsmittel (54) zum Koppeln der Detektionseinheit mit dem zweiten Kontakt (22), um das resultierende Prüfsignal zu empfangen,
wobei mindestens eines von dem ersten und zweiten Kopplungsmittel eine galvanische Trennung zu den ersten und zweiten Kontakten (21, 22) bereitstellt,
- wobei das erste Kopplungsmittel (53) zwischen dem ersten Kontakt (21) und Erde verbunden ist, und wobei das zweite Kopplungsmittel (54) zwischen dem zweiten Kontakt (22) und Erde verbunden ist, **dadurch gekennzeichnet, dass** das erste Kopplungsmittel (53) einen ersten Übertrager (56) in Reihe mit einem ersten Überspannungsschutzkondensator (57) auf einer Sekundärseite des ersten Übertragers (56) umfasst, wobei die Einspeisungseinheit (51) mit dem ersten Übertrager (56) verbunden ist, um das transiente Prüfsignal in den ersten Kontakt (21) zu koppeln, wobei ein periodisches Prüfsignal mittels des ersten Übertragers (56) bei einer Resonanzfrequenz eingespeist wird, die hauptsächlich durch die Kapazität des ersten Überspannungsschutzkondensators (57) und dessen Streuinduktivität bestimmt wird.

3. Vorrichtung nach Anspruch 1 oder 2, wobei das zweite Kopplungsmittel (52) einen kapazitiven Koppler umfasst, der eine Kapazität (55) aufweist, welche die Detektionseinheit (54) mit dem zweiten Kontakt (22) verbindet, um das resultierende Prüfsignal von dem zweiten Kontakt (22) zu empfangen.

4. Vorrichtung nach einem der Ansprüche 1 bis 3, wobei das zweite Kopplungsmittel (54) einen zweiten Übertrager (58) in Reihe mit einem zweiten Überspannungsschutzkondensator (59) aufweist, wobei die Detektionseinheit (52) mit dem zweiten Übertrager (58) verbunden ist, um das transiente Prüfsignal von dem zweiten Kontakt (22) zu empfangen.

5. Vorrichtung nach den Ansprüchen 1 bis 4, wobei die Detektionseinheit ferner einen zweiten Resonanzinduktor (522) aufweist, wobei die Resonanzfrequenz, die durch die Induktivität des zweiten Resonanzinduktors (522) und die Induktivität und Kapazität des zweiten Kopplungsmittels (54) bestimmt ist, einer Frequenz entspricht, die sich nicht mehr als 10% von der Resonanzfrequenz unterscheidet, die durch die Induktivität des ersten Resonanzinduktors (512) und die Induktivität und Kapazität des ersten Kopplungsmittels (53) bestimmt ist.

6. Vorrichtung nach einem der Ansprüche 1 bis 5, wobei eine Steuereinheit (20) konfiguriert ist, Anzeichenüber einen ersten Zeitpunkt des Schließens oder Öffnens eines Hauptkontaktpaars (23, 25) und einen zweiten Zeitpunkt des Schließens oder entsprechenden Öffnens eines Abbrandkontaktpaars (24, 26) zu empfangen, um eine Zeitverzögerung zwischen dem ersten und dem zweiten Zeitpunkt des Schließens oder zwischen dem ersten und dem zweiten Zeitpunkt des Öffnens zu bestimmen und einen schlechten Zustand des Leistungsschalters (2) abhängig von der bestimmten Zeitverzögerung zu signalisieren.

7. Vorrichtung nach einem der Ansprüche 1 oder 3, wobei die kapazitiven Koppler des ersten und zweiten Kopplungsmittels (53, 54) jeweils zwei in Reihe verbundene Kondensatoren (55) aufweisen, und wobei die erste Reihenschaltung der Kondensatoren (55) zwischen dem ersten Kontakt (21) des Leistungsschalters (2) und einem Erdpotenzial gekoppelt ist und die zweite Reihenschaltung der Kondensatoren (55) zwischen dem zweiten Kontakt (22) des Leistungsschalters (2) und dem Erdpotenzial gekoppelt ist, und wobei ein Zwischenknoten zwischen den Kondensatoren (55) der Reihenschaltung des ersten Kopplungsmittels (53) mit dem Resonanzinduktor (512) der Einspeisungseinheit (51) gekoppelt ist, und wobei ein Zwischenknoten zwischen den Kondensatoren (55) der Reihenschaltung des zweiten Kopplungsmittels (54) mit dem Resonanzinduktor (522) der Detektionseinheit (52) verbunden ist.

8. Vorrichtung nach Anspruch 7, wobei der erste Resonanzinduktor (512) mit einer ersten Schutzschaltung (514) in Reihe verbunden ist, die sich zwischen dem Zwischenknoten des ersten Kopplungsmittels (53) und dem ersten Resonanzinduktor (512) befindet.

9. Steuereinheit (20) zur Verwendung mit einer Vorrichtung nach Anspruch 1 bis 8, wobei die Steuereinheit (20) konfiguriert ist, Anzeichen über einen ersten Zeitpunkt des Schließens oder Öffnens eines Hauptkontaktpaars (23, 25) von einem Leistungsschalter (2) und einen zweiten Zeitpunkt des Schließens oder entsprechenden Öffnens eines Abbrandkontaktpaars (24, 26) von einem Leistungsschalter (2) zu empfangen, um eine Zeitverzögerung zu bestimmen und einen schlechten Zustand des Leistungsschalters (2) abhängig von der bestimmten Zeitverzögerung zu signalisieren.

10. System, aufweisend:
- einen Leistungsschalter (2) mit einem ersten Kontakt (21) und einem zweiten Kontakt (22); und
- eine Vorrichtung nach einem der Ansprüche 1 bis 7.

11. System nach Anspruch 10 und aufweisend eine Steuereinheit (20) nach Anspruch 10.

12. System nach Anspruch 10 oder 11, wobei der erste Kontakt (21) eine erste Hauptkontaktregion (23) und eine erste Abbrandkontaktregion (24) aufweist und der zweite Kontakt (22) eine zweite Hauptkontaktregion (25) und eine zweite Abbrandkontaktregion (26) aufweist, wobei die ersten und zweiten Hauptkontaktregionen (23, 25) ein Hauptkontaktpaar bilden (23, 25), das eine niedrigere erste Impedanz im geschlossenen Zustand aufweist, und wobei die ersten und zweiten Abbrandkontaktregionen (24, 26) ein Abbrandkontaktpaar bilden (24, 26), das eine höhere zweite Impedanz im geschlossenen Zustand aufweist, wobei beim Schließen des Leistungsschalters (2) das Abbrandkontaktpaar (24, 26) zuerst geschlossen wird und beim Öffnen des Leistungsschalters (2) das Hauptkontaktpaar (23, 25) zuerst geöffnet wird.

13. System nach irgendeinem der Ansprüche 10 bis 12, wobei der Leistungsschalter (2) ein Generatorleistungsschalter ist.

14. Verfahren zum Messen eines Zustandes eines Leistungsschalters (2) unter Verwendung einer Vorrichtung nach einem der Ansprüche 1 bis 8, wobei Anzeichen über einen ersten Zeitpunkt des Schließens oder Öffnens eines Hauptkontaktpaars (23, 25) eines Leistungsschalters (2) und über einen zweiten Zeitpunkt des Schließens oder entsprechenden Öffnens eines Abbrandkontaktpaars (24, 26) von dem Leistungsschalter (2) erlangt werden, wobei eine Zeitverzögerung zwischen dem ersten Zeitpunkt und dem zweiten Zeitpunkt bestimmt wird und ein schlechter Zustand des Leistungsschalters (2) abhängig von der bestimmten Zeitverzögerung signalisiert wird, wobei das transiente Prüfsignal in den ersten Kontakt (21) gekoppelt wird und das Prüfsignal an dem zweiten Kontakt (22) detektiert wird, während mindestens einer von den ersten und zweiten Kontakten spannungsführend ist.

15. Verfahren nach Anspruch 14, wobei die Messung des Zustandes des Leistungsschalters (2) unter Spannung während des normalen Betriebs des Leistungsschalters (2) ausgeführt wird.

## Revendications

1. Appareil pour surveiller un état d'un disjoncteur (2), comprenant :
une unité d'injection (51) pour injecter un signal de test transitoire dans un premier contact du disjoncteur ;
une unité de détection (52) pour détecter un signal transitoire résultant au niveau d'un second contact du disjoncteur ;
un premier moyen de couplage (53) pour coupler le signal de test transitoire délivré par l'unité d'injection dans le premier contact (21) ; et
un second moyen de couplage (54) pour coupler l'unité de détection au second contact (22) pour recevoir le signal de test résultant,
où au moins un des premier et second moyens de couplage fournissent une séparation galvanique par rapport aux premier et second contacts (21, 22),
où le premier moyens de couplage (53) est connecté entre le premier contact (21) et la masse et où le second moyen de couplage (54) est connecté entre le second contact (22) et la masse,
**caractérisé en ce que** le premier moyen de couplage (53) comprend un coupleur capacitif comprenant une capacitance (55) connectant l'unité d'injection (51) au premier contact (21) pour coupler le signal de test transitoire dans le premier contact (21) et où l'unité d'injection (51) comprend en outre un premier inducteur de correction (512), et où une fréquence du signal de test injecté correspond à une fréquence qui ne diffère pas de plus de 10 % de la fréquence de résonnance déterminée par l'inductance du premier inducteur de correction (512) et l'inductance et la capacitance du premier moyen de couplage (53).

2. Appareil pour surveiller un état d'un disjoncteur (2), comprenant :
une unité d'injection (51) pour injecter un signal de test transitoire dans un premier contact du disjoncteur (2) ;
une unité de détection (52) pour détecter un signal transitoire résultant au niveau d'un second contact du disjoncteur ;
un premier moyen de couplage (53) pour coupler le signal de test transitoire délivré par l'unité d'injection dans le premier contact (21) ; et
un second moyen de couplage (54) pour coupler l'unité de détection au second contact (22) pour recevoir le signal de test résultant,
où au moins un des premier et second moyens de couplage fournissent une séparation galvanique par rapport aux premier et second contacts (21, 22),
où le premier moyen de couplage (53) est connecté entre le premier contact (21) et la masse et où le second moyen de couplage (54) est connecté entre le second contact (22) et la masse, **caractérisé en ce que** le premier moyen de couplage (53) comprend un premier transformateur (56) en ligne avec un premier condensateur de surtension (57) sur un côté secondaire du premier transformateur (56),
où l'unité d'injection (51) est connectée au premier transformateur (56) pour coupler le signal de test transitoire dans le premier contact (21), où un signal de test périodique est injecté au moyen du premier transformateur (56) à une fréquence de résonnance principalement déterminée par la capacitance du premier condensateur de surtension (57) et son inductance parasite.

3. Appareil selon la revendication 1 ou la revendication 2, dans lequel le second moyen de couplage (52) comprend un coupleur capacitif comprenant une capacitance (55) connectant l'unité de détection (54) avec le second contact (22) pour recevoir le signal de test résultant depuis le second contact (22).

4. Appareil selon l'une quelconque des revendications 1 à 3, dans lequel le second moyen de couplage (54) comprend un second transformateur (58) en ligne avec un second condensateur de surtension (59), où l'unité de détection (52) est connectée au second transformateur (58) pour recevoir le signal de test transitoire depuis le second contact (22).

5. Appareil selon les revendications 1 à 4, dans lequel l'unité de détection comprend en outre un second inducteur de correction (522), où la fréquence de résonance qui est déterminée par l'inductance du second inducteur de correction (522) et l'inductance et la capacité du second moyen de couplage (54) correspond à une fréquence qui ne diffère pas de plus de 10 % de la fréquence de résonnance déterminée par l'inductance du premier inducteur de correction (512) et l'inductance et la capacitance du premier moyen de couplage (53).

6. Appareil selon l'une quelconque des revendications 1 à 5, dans lequel une unité de commande (20) est configurée pour recevoir des indications concernant un premier temps de fermeture ou d'ouverture d'une paire de contacts principaux (23, 25) et un second temps de fermeture ou respectivement d'ouverture d'une paire de contacts d'arc (24, 26) pour déterminer une temporisation entre le premier temps et le second temps de fermeture ou entre le premier temps et le second temps d'ouverture, et pour signaler un mauvais état du disjoncteur (2) en fonction de la temporisation déterminée.

7. Appareil selon l'une des revendications 1 ou 3, dans lequel les coupleurs capacitifs des premier et second moyens de couplage (53, 54) comprennent chacun deux condensateurs connectés en série (55), et où la première connexion en série des condensateurs (55) est couplée entre le premier contact (21) du disjoncteur (2) et un potentiel à la masse, et la seconde connexion en série des condensateurs (55) est couplée entre le second contact (22) du disjoncteur (2) et le potentiel à la masse, et où un noeud intermédiaire entre les condensateurs (55) de la connexion en série du premier moyen de couplage (53) est couplé à l'inducteur de correction (512) de l'unité d'injection (51), et où un noeud intermédiaire entre les condensateurs (55) de la connexion en série du second moyen de couplage (54) est connecté à l'inducteur de correction (522) de l'unité de détection (52).

8. Appareil selon la revendication 7, dans lequel le premier inducteur de correction (512) est connecté en série à un premier circuit de protection (514), qui est situé entre le noeud intermédiaire du premier moyen de couplage (53) et le premier inducteur de correction (512).

9. Unité de commande (20) destinée à être utilisée avec un appareil selon les revendications 1 à 8, où l'unité de commande (20) est configurée pour recevoir des indications concernant un premier temps de fermeture ou d'ouverture d'une paire de contacts principaux (23, 25) d'un disjoncteur (2) et un second temps de fermeture ou respectivement d'ouverture d'une paire de contacts d'arc (24, 26) d'un disjoncteur (2) pour déterminer une temporisation et pour signaler un mauvais état du disjoncteur (2) en fonction de la temporisation déterminée.

10. Système comprenant :
un disjoncteur (2) ayant un premier contact (21) et un second contact (22) ; et
un appareil selon l'une quelconque des revendications 1 à 7.

11. Système selon la revendication 10 et comprenant une unité de commande (20) selon la revendication 10.

12. Système selon la revendication 10 ou la revendication 11, dans lequel le premier contact (21) a une première région de contact principale (23) et une première région de contact d'arc (24) et le second contact (22) a une seconde région de contact principale (25) et une seconde région de contact d'arc (26), où les première et seconde régions de contact principales (23, 25) forment une paire de contacts principaux (23, 25) ayant une première impédance plus faible dans un état fermé, et où les première et seconde régions de contact d'arc (24, 26) forment une paire de contacts d'arc (24, 26) ayant une seconde impédance plus élevée dans un état fermé, où lors de la fermeture du disjoncteur (2) la paire de contacts d'arc (24, 26) est tout d'abord fermée et lors de l'ouverture du disjoncteur (2) la paire de contacts principaux (23, 25) est tout d'abord ouverte.

13. Système selon l'une quelconque des revendications 10 à 12, dans lequel le disjoncteur (2) est un disjoncteur de générateur.

14. Procédé pour mesurer un état d'un disjoncteur (2) au moyen d'un appareil selon l'une quelconque des revendications 1 à 8, dans lequel des indications concernant un premier temps de fermeture ou d'ouverture d'une paire de contacts principaux (23, 25) d'un disjoncteur (2) est obtenue, et un second temps de fermeture ou respectivement d'ouverture d'une paire de contacts d'arc (24, 26) du disjoncteur (2) est obtenue, où une temporisation entre le premier temps et le second temps est déterminée et un mauvais état du disjoncteur (2) est signalé en fonction de la temporisation déterminée, où le signal de test transitoire est couplé dans le premier contact (21) et le signal de test est détecté sur le second contact (22) tandis qu'au moins un des premier et second contacts est sous tension.

15. Procédé selon la revendication 14, dans lequel la mesure de l'état du disjoncteur (2) est effectuée en ligne au cours du fonctionnement normal du disjoncteur (2) .
